# EUROPEAN PATENT SPECIFICATION

(11) **EP 2 720 522 B1**
(45) Date of publication and mention of the grant of the patent: **04.07.2018**
(21) Application number: 14150937.2
(22) Date of filing: 19.05.2010
(51) Int. Cl.: H05K 7/14

(54) **Plug-in unit assembly**
Einsteckanordnung
Ensemble d'unité enfichable

(43) Date of publication of application: 16.04.2014
(62) Divisional of application: 10163244.6
(73) Proprietor: ABB Technology AB, 8050 Zürich (CH)
(72) Inventor: Kangas, Simo, 65350 VAASA (FI)
(74) Representative: Kinnunen, Kari Tapio

(56) References cited:
- US-A1- 2009 080 165
- US-B1- 6 222 736
- US-B1- 6 231 144

## Description

### BACKGROUND OF THE INVENTION

The invention relates to a plug-in unit assembly comprising a case and a plug-in unit arranged to be removably connected to the case.

An example of a known plug-in unit assembly is described in publication US 7,175,470, which discloses a plug-in unit assembly having a handle by turning of which a plug-in unit may be pushed slightly outwards from a case. Such an arrangement enables a reduction in the force required to detach the plug-in unit from the case. Examples of other known plug-in unit assemblies are described in publications US 2009/080165 A1, US 6222736 B1 and US 6137684.

In a plug-in unit assembly having a plurality of electrical connectors adapted to be coupled when the plug-in unit is connected to the case, it may be necessary to reduce the force required to connect the plug-in unit to the case. This is particularly the case when the plurality of electrical connectors consists of electrical connectors having high rated currents. Typically a required connecting force of an electrical connector correlates with a rated current of the electrical connector; the higher the rated current, the greater the required connecting force. The above-mentioned publication US 7,175,470 does not discuss the matter of reducing the force required to connect the plug-in unit to the case.

### BRIEF DESCRIPTION OF THE INVENTION

An object of the invention is to provide a plug-in unit assembly which helps to reduce the force required to connect a plug-in unit to a case. The object of the invention is achieved by a plug-in unit assembly which is characterized in what is stated in the independent claim. Preferred embodiments are described in the dependent claims.

The invention is based on an idea of providing a plug-in unit with an actuating member which can be moved between a locking position and a releasing position by turning a handle of the plug-in unit, the actuating member being arranged to co-operate with the case for moving the plug-in unit to a plugged-in position in response to movement of the actuating member from the releasing position to the locking position.

The plug-in unit assembly according to the invention enables a reduction in the force required to connect a plug-in unit to a case.

### BRIEF DESCRIPTION OF THE FIGURES

In the following, preferred embodiments of the invention will be described in closer detail with reference to the accompanying drawings, in which
Figure 1 shows a plug-in unit assembly according to an embodiment of the invention, the plug-in unit of the assembly being in a detached position;
Figure 2 shows the plug-in unit assembly of Figure 1, the plug-in unit being in a plugged-in position;
Figure 3 shows the plug-in unit assembly of Figure 1, the plug-in unit being in an outer plugging position;
Figure 4 shows a side view of an actuating member;
Figure 5 shows an upper corner of an interior of a unit body of the plug-in unit;
Figures 6 and 7 illustrate mounting of an actuating member into the plug-in unit;
Figure 8 is a sectional view showing the plug-in unit assembly of Figure 1, the plug-in unit being in the outer plugging position;
Figure 9 shows the plug-in unit assembly of Figure 8, the plug-in unit being in an intermediate position; and
Figure 10 shows the plug-in unit assembly of Figure 8, the plug-in unit being in the plugged-in position.

### DETAILED DESCRIPTION OF THE INVENTION

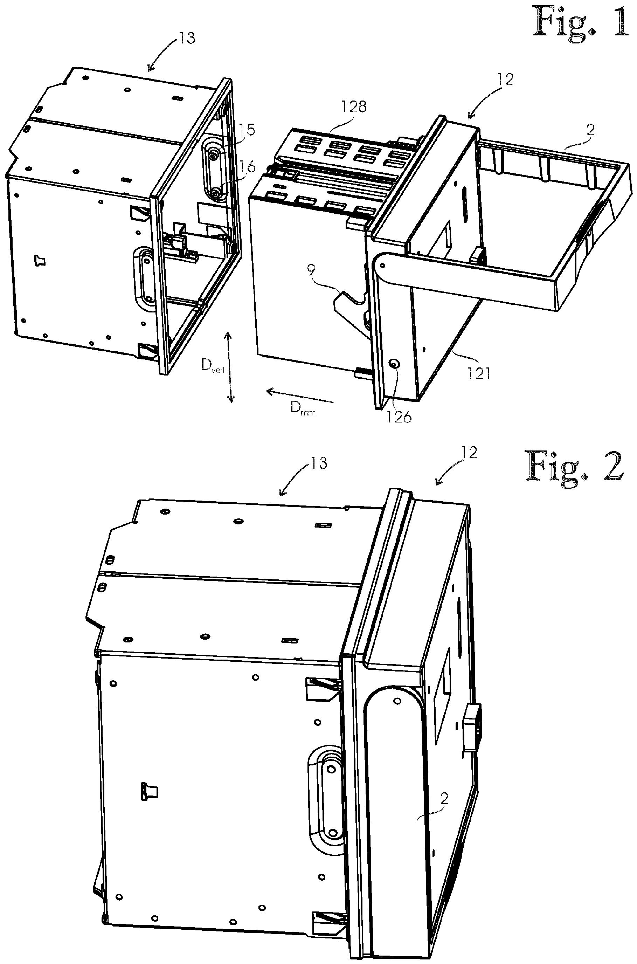

Figure 1 shows a plug-in unit assembly comprising a case 13 and a plug-in unit 12 arranged to be removably connected to the case 13. The plug-in unit 12 has a plugged-in position and a detached position in relation to the case 13. In Figure 1, the plug-in unit 12 is in the detached position, wherein the plug-in unit 12 is completely detached from the case 13. The plugged-in position is shown in Figure 2.

The plug-in unit 12 comprises a unit body 121, a unit housing 128, a handle 2 and an actuating member 9. The unit housing 128 is immovably connected to the unit body 121 and is adapted to be received inside the case 13 when the plug-in unit 12 is in the plugged-in position. The handle 2 is pivotally connected to the unit body 121 for pivoting between a normal position and a mounting position in relation to the unit body 121. The actuating member 9 is movably connected to the unit body 121 for movement between a locking position and a releasing position in relation to the unit body 121. In Figure 1, the handle 2 is in the mounting position and the actuating member 9 is in the releasing position. The normal position of the handle is shown in Figure 2.

The handle 2 is operationally connected to the actuating member 9 such that pivoting the handle 2 from the mounting position to the normal position moves the actuating member 9 from the releasing position to the locking position. Correspondingly, pivoting the handle 2 from the normal position to the mounting position moves the actuating member 9 from the locking position to the releasing position.

The case 13 comprises a locking counterpart element 15 and a releasing counterpart element 16. The locking counterpart element 15 and the releasing counterpart element 16 are spaced apart and located on a vertical line, the vertical line being parallel with a vertical direction Dᵥₑᵣₜ perpendicular in relation to both the pivoting axis of the handle 2 and a mounting direction Dₘₙₜ, the mounting direction Dₘₙₜ being a direction in which the plug-in unit 12 is adapted to be pushed when connecting the plug-in unit 12 to the case 13. Both the locking counterpart element 15 and the releasing counterpart element 16 are formed by heads of corresponding hexagonal socket-head screws screwed from inside the unit body 121. A peripheral surface of the head of each of the hexagonal socket-head screws is a symmetrical and cylindrical surface having a symmetry axis parallel with the pivoting axis of the handle 2.

In an alternative embodiment, both the locking counterpart element and the releasing counterpart element are formed by portions of shanks of screws. The portions of shanks may or may not comprise threading. In this kind of alternative embodiment, the screws are screwed from outside the unit body.

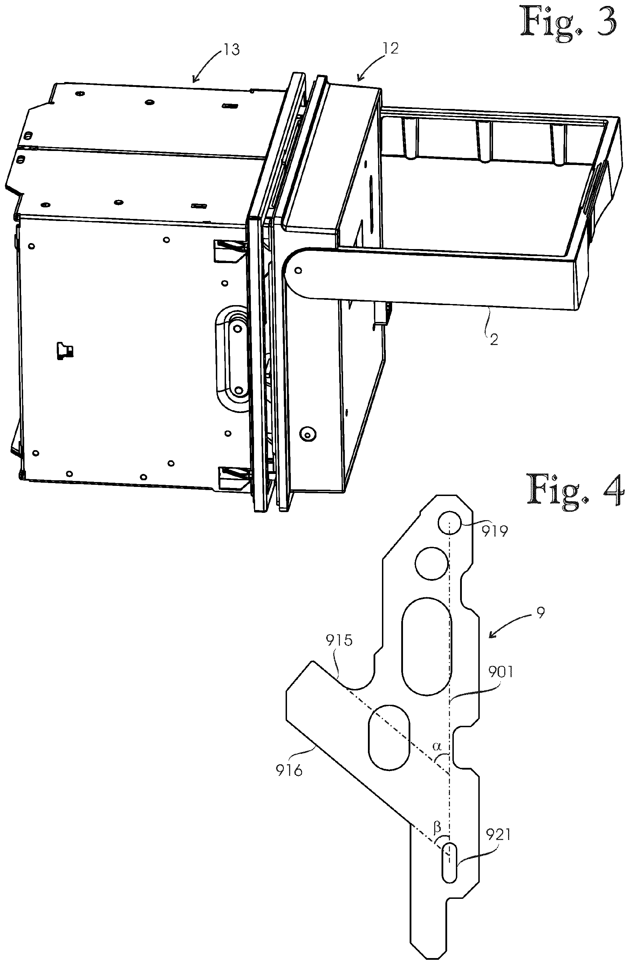

The locking counterpart element 15 is adapted to co-operate with the actuating member 9 for moving the plug-in unit 12 from an outer plugging position to the plugged-in position in response to movement of the actuating member 9 from the releasing position to the locking position, the outer plugging position being located at a predetermined plugging distance from the plugged-in position towards the detached position. The outer plugging position of the plug-in unit 12 is shown in Figure 3. Further, the locking counterpart element 15 is adapted to co-operate with the actuating member 9, while the actuating member 9 is in the locking position, in order to prevent movement of the plug-in unit 12 from the plugged-in position towards the detached position.

In an embodiment, the plug-in unit comprises at least one electrical component having an electrical connector arranged to be coupled to a corresponding mating connector installed in the case when the plug-in unit is being attached to its case. In such an embodiment, the outer plugging position is located such that substantially the entire coupling event, i.e. the coupling of the electrical connector to the mating connector, takes place between the outer plugging position and the plugged-in position. This reduces the force required to connect the plug-in unit to the case.

The releasing counterpart element 16 is adapted to co-operate with the actuating member 9 for moving the plug-in unit 12 from the plugged-in position to an outer releasing position in relation to the case 13 in response to movement of the actuating member 9 from the locking position to the releasing position, the outer releasing position being located at a predetermined release distance from the plugged-in position towards the detached position. In the depicted embodiment, the outer releasing position is equal to the outer plugging position shown in Figure 3. In an alternative embodiment, there is a distance between the outer plugging position and the outer releasing position.

The locking counterpart element 15 is located in the upper half of the case 13. The releasing counterpart element 16 is located in the lower half of the case 13. The distance between the locking counterpart element 15 and the upper surface of the case 13 is identical to the distance between the releasing counterpart element 16 and the lower surface of the case 13.

Figure 4 shows a side view of the actuating member 9. A circular connecting aperture 919 is provided on the upper end of the actuating member 9, and a linearly extending guiding slot 921 on the lower end of the actuating member 9. The actuating member 9 also comprises a locking surface 915 arranged to co-operate with the locking counterpart element 15, and a releasing surface 916 arranged to co-operate with the releasing counterpart element 16. Both the locking surface 915 and the releasing surface 916 extend perpendicularly in relation to the image plane of Figure 4 and are narrow, planar surfaces.

The locking surface 915 forms an angle α in relation to an actuating member centre line 901 which extends between a centre point of the connecting aperture 919 and a centre point of the guiding slot 921. The releasing surface 916 forms an angle β in relation to the actuating member centre line 901. In the embodiment of Figure 4, both the angle α and the angle β are approximately 50°. In alternative embodiments, the angles α and β may be in a range of 30° to 70°.

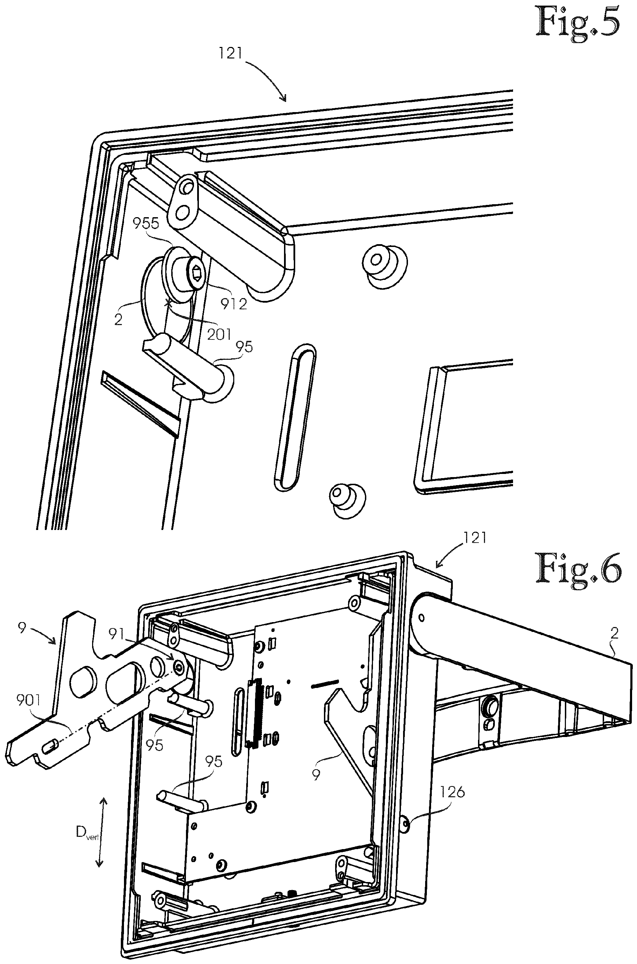

Figure 5 shows an upper corner of the interior of the unit body 121. A pivotal shaft 912 is formed on the handle 2, the pivotal shaft 912 having a free end adapted to be received in the connecting aperture 919 of the actuating member 9. The pivotal shaft 912 is located at a distance from a pivoting axis of the handle 2 and it allows the actuating member 9 to pivot in relation to the handle 2. A point through which the pivoting axis of the handle 2 passes is denoted with reference numeral 201. The pivotal shaft 912 is formed by a head of a hexagonal socket-head screw. The screw is screwed into the handle 2. Under the head of the screw a washer 955 is provided which prevents release of the handle 2 from the unit body 121.

In an alternative embodiment, the pivotal shaft is formed by a portion of a shank of a screw. The screw may be screwed into the handle from outside the unit body. In a further alternative embodiment, a screw is screwed into the actuating member and a portion of the screw forms the pivotal shaft. In the further alternative embodiment, the connecting aperture is provided on the handle.

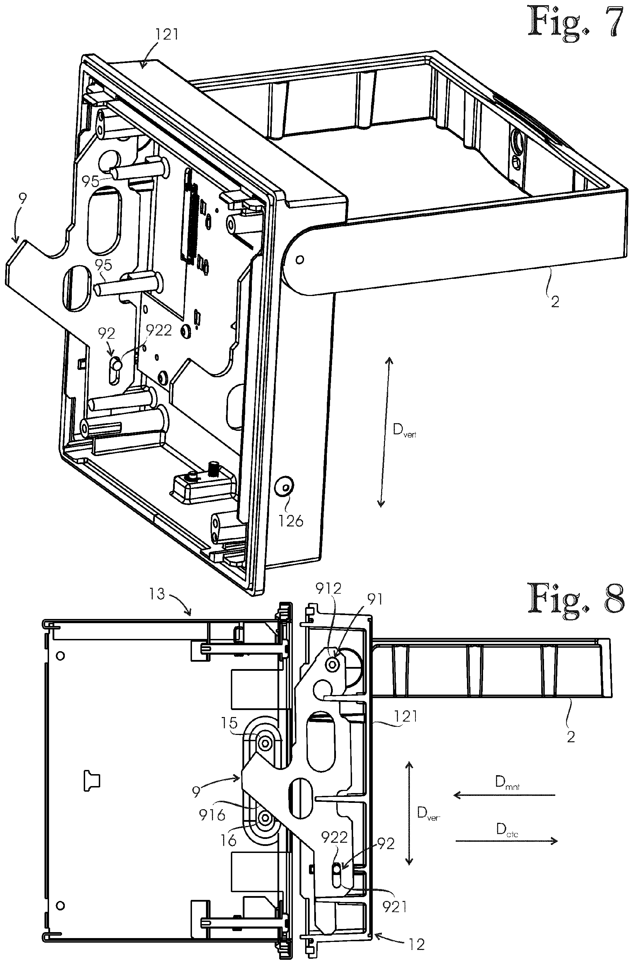

Figures 6 and 7 illustrate mounting of the actuating member 9 into the plug-in unit 12. In Figures 6 and 7, no unit housing 128 is shown. In Figure 6, the pivotal shaft 912 has been fitted in the connecting aperture 919 of the actuating member 9 in order to provide an off-centre pivotal connection 91. The off-centre pivotal connection 91 is located at a distance from the pivoting axis of the handle 2 and it allows the actuating member 9 to pivot in relation to the handle 2. In Figure 6, the actuating member 9 is in a position where the actuating member centre line 901 extends at an angle greater than 45° in relation to the vertical direction Dᵥₑᵣₜ. This position of the actuating member 9 enables the pivotal shaft 912 to be fitted into the connecting aperture 919.

After the pivotal shaft 912 has been fitted in the connecting aperture 919, the actuating member 9 is pivoted around the pivotal shaft 912 into a position where the actuating member centre line 901 extends substantially parallel with the vertical direction Dᵥₑᵣₜ as depicted in Figure 7. Finally, a support screw 126 is screwed into the guiding slot 921 in order to provide a guiding slot connection 92. The support screw 126 has a free end which forms a slot pin 922 adapted to co-operate with the guiding slot 921 by sliding in the guiding slot 921. The support screw 126 is screwed from outside the unit body 121.

Figure 7 shows that a lateral movement of the actuating member 9 is prevented when the actuating member centre line 901 extends substantially parallel with the vertical direction Dᵥₑᵣₜ. Herein, the lateral movement of the actuating member 9 is parallel with the pivoting axis of the handle 2. On one side, the lateral movement of the actuating member 9 is prevented by an inner side surface of the unit body 121, and on the other side the lateral movement of the actuating member 9 is prevented by guide pins 95.

Figures 8 to 10 show a sectional view of the plug-in unit assembly, illustrating the operation of the actuating member 9. As discussed above, the upper part of the actuating member 9 is pivotally connected to the handle 2 through the off-centre pivotal connection 91 which allows the actuating member 9 to pivot in relation to the handle 2. The lower part of the actuating member 9 is connected to the unit body 121 through the guiding slot connection 92 as explained above.

In Figure 8, the handle 2 is in the mounting position, the actuating member 9 is in the releasing position, and the plug-in unit 12 is in the outer plugging position. The releasing surface 916 of the actuating member 9 is in contact with the releasing counterpart element 16. The locking surface 915 is at a distance from the locking counterpart element 15.

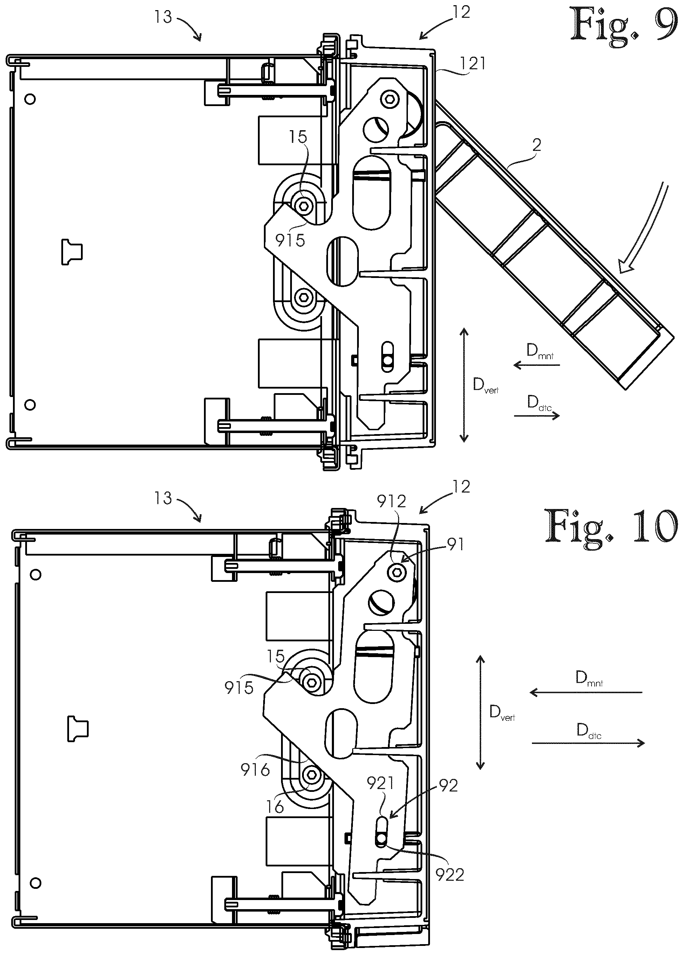

In Figure 10, the handle 2 is in the normal position, the actuating member 9 is in the locking position, and the plug-in unit 12 is in the plugged-in position. The locking surface 915 of the actuating member 9 is in contact with the locking counterpart element 15. The releasing surface 916 is at a distance from the releasing counterpart element 16.

The movement of the plug-in unit 12 from the outer plugging position of Figure 8 to the plugged-in position of Figure 10 is achieved by turning the handle 2 from the mounting position to the normal position. The turning of the handle 2 moves the actuating member 9 from the releasing position to the locking position owing to the off-centre pivotal connection 91 which moves the pivotal shaft 912 upwards and in a detaching direction D_{dtc} in relation to the unit body 121. Herein, the upwards direction is a direction parallel to the vertical direction Dᵥₑᵣₜ and directed away from the slot pin 922. The detaching direction D_{dtc} is a direction opposite to the mounting direction Dₘₙₜ.

Figure 9 illustrates an intermediate state between the states illustrated in Figures 8 and 10. In the intermediate state, the locking surface 915 co-operates with the locking counterpart element 15 transferring forces that move the plug-in unit 12 towards the plugged-in position.

Figures 8 to 10 show that the handle 2 provides a long lever arm, almost as long as the height of the front surface of the unit body 121. This is made possible by locating the pivoting axis of the handle 2 near the upper surface of the unit body 121. The long lever arm of the handle 2 reduces the force necessary to operate the handle 2.

It is obvious to a person skilled in the art that the basic idea of the invention can be implemented in a variety of ways. The invention and its embodiments are thus not limited to the above examples, but may vary within the scope of the claims.

## Claims

1. A plug-in unit assembly comprising a case (13) and a plug-in unit (12) arranged to be removably connected to the case (13), the plug-in unit (12) having a plugged-in position and a detached position in relation to the case (13);
the plug-in unit (12) comprising a unit body (121), a handle (2) and an actuating member (9), the handle (2) being pivotally connected to the unit body (121) for pivoting between a normal position and a mounting position in relation to the unit body (121), the actuating member (9) being movably connected to the unit body (121) for movement between a locking position and a releasing position in relation to the unit body (121), the handle (2) being operationally connected to the actuating member (9) such that pivoting the handle (2) from the mounting position to the normal position moves the actuating member (9) from the releasing position to the locking position and pivoting the handle (2) from the normal position to the mounting position moves the actuating member (9) from the locking position to the releasing position; wherein the case (13) comprises a locking counterpart element (15) and a releasing counterpart element (16), the actuating member (9) comprises a locking surface (915) arranged to co-operate with the locking counterpart element (15), and a releasing surface (916) arranged to co-operate with the releasing counterpart element (16), the locking counterpart element (15) being adapted to co-operate with the actuating member (9) for moving the plug-in unit (12) from an outer plugging position to the plugged-in position in response to movement of the actuating member (9) from the releasing position to the locking position, the outer plugging position being located at a predetermined plugging distance from the plugged-in position towards the detached position, and
the releasing counterpart element (16) is adapted to co-operate with the actuating member (9) for moving the plug-in unit (12) from the plugged-in position to an outer releasing position in relation to the case (13) in response to movement of the actuating member (9) from the locking position to the releasing position, the outer releasing position being located at a predetermined release distance from the plugged-in position towards the detached position, **characterized in that** the actuating member (9) is pivotally connected to the handle (2) through an off-centre pivotal connection (91), the off-centre pivotal connection (91) being located at a distance from a pivoting axis of the handle (2) and allowing the actuating member (9) to pivot in relation to the handle (2), and
the off-centre pivotal connection (91) comprises
a pivotal shaft (912) provided on one of the handle (2) and the actuating member (9), the pivotal shaft (912) having a free end; and
a connecting aperture (919) provided on the other of the handle (2) and the actuating member (9), the connecting aperture (919) being adapted to receive the free end of the pivotal shaft (912) for achieving the off-centre pivotal connection (91).

2. A plug-in unit assembly as claimed in claim 1, **characterized in that** the pivotal shaft (912) is provided on the handle (2), and the connecting aperture (919) is provided on the actuating member (9).

3. A plug-in unit assembly as claimed in any preceding claim, **characterized in that** the actuating member (9) is connected to the unit body (121) through a guiding slot connection (92), the guiding slot connection (92) comprising a guiding slot (921) provided on one of the actuating member (9) and the unit body (121), and a slot pin (922) provided on the other of the actuating member (9) and the unit body (121), the slot pin (922) being adapted to co-operate with the guiding slot (921) by sliding in the guiding slot (921).

4. A plug-in unit assembly as claimed in claim 3, **characterized in that** the guiding slot (921) extends linearly.

5. A plug-in unit assembly as claimed in claim 3 or 4, **characterized in that** the guiding slot (921) is provided on the actuating member (9), and the slot pin (922) is provided on the unit body (121).

6. A plug-in unit assembly as claimed in claim 3, **characterized in that** both the locking surface (915) and the releasing surface (916) are planar surfaces, the locking surface (915) forming an angle α in relation to an actuating member centre line (901) which extends between a centre point of the connecting aperture (919) and a centre point of the guiding slot (921), and the releasing surface (916) forming an angle β in relation to the actuating member centre line (901).

7. A plug-in unit assembly as claimed in claim 6, **characterized in that** both the angle α and the angle β are in a range of 30° to 70°.

8. A plug-in unit assembly as claimed in any of claims 1, 6 or 7, **characterized in that** the locking counterpart element (15) comprises a peripheral surface adapted to co-operate with the locking surface (915), and the releasing counterpart element (16) comprises a peripheral surface adapted to co-operate with the releasing surface (916), each of the peripheral surfaces being a symmetrical and cylindrical surface having a symmetry axis parallel with the pivoting axis of the handle (2).

9. A plug-in unit assembly as claimed in claim 1, **characterized in that** at least one of the following: the pivotal shaft (912), the locking counterpart element (15) and the releasing counterpart element (16) is formed by a portion of a screw.

10. A plug-in unit assembly as claimed in any preceding claim, **characterized in that** the locking counterpart element (15) and the releasing counterpart element (16) are spaced apart and located on a vertical line, the vertical line being parallel with a vertical direction (Dᵥₑᵣₜ) perpendicular in relation to both the pivoting axis of the handle (2) and a mounting direction (Dₘₙₜ), the mounting direction (Dₘₙₜ) being a direction in which the plug-in unit (12) is adapted to be pushed when connecting the plug-in unit (12) to the case (13).

11. A plug-in unit assembly as claimed in any preceding claim, **characterized in that** the off-centre pivotal connection (91) is located such that turning of the handle (2) from the mounting position to the normal position moves the pivotal shaft (912) upwards and in a detaching direction (D_{dtc}), the upwards direction being a direction parallel to the vertical direction (Dᵥₑᵣₜ) and directed away from the guiding slot connection (92), the detaching direction (D_{dtc}) being a direction opposite to the mounting direction (Dₘₙₜ).

12. A plug-in unit assembly as claimed in any preceding claim, **characterized in that** the actuating member (9) is adapted, while in the locking position, to co-operate with the locking counterpart element (15) in order to prevent movement of the plug-in unit (12) from the plugged-in position towards the detached position.

## Patentansprüche

1. Einschubbaugruppe umfassend ein Gehäuse (13) und eine Einschubeinheit (12), die zur lösbaren Verbindung mit dem Gehäuse (13) angeordnet ist, wobei die Einschubeinheit (12) eine Einschubposition und eine gelöste Position in Bezug auf das Gehäuse (13) aufweist;
Einschubeinheit (12) umfassend einen Einheitenkörper (121), einen Griff (2) und ein Betätigungselement (9), wobei der Griff (2) schwenkbar mit dem Einheitenkörper (121) verbunden ist, um zwischen einer Normalposition und einer Montageposition in Bezug auf den Einheitenkörper (121) zu schwenken, wobei das Betätigungselement (9) verschiebbar mit dem Einheitenkörper (121), zum Bewegen zwischen einer Verriegelungsposition und einer Freigabeposition in Bezug auf den Einheitenkörper (121), verbunden ist, wobei der Griff (2) funktionsfähig mit dem Betätigungselement (9) verbunden ist, sodass das Schwenken des Griffs (2) aus der Montageposition in die Normalposition das Betätigungselement (9) aus der Freigabeposition in die Verriegelungsposition bewegt und das Schwenken des Griffs (2) aus der Normalposition in die Montageposition das Betätigungselement (9) aus der Verriegelungsposition in die Freigabeposition bewegt;
worin das Gehäuse (13) ein verriegelndes Gegenstückelement (15) und ein freigebendes Gegenstückelement (16) umfasst, wobei das Betätigungselement (9) eine Verriegelungsfläche (915) umfasst, die so angeordnet ist, dass sie mit dem verriegelnden Gegenstückelement (15) zusammenwirkt, und eine Freigabefläche (916), die so angeordnet ist, dass sie mit dem freigebenden Gegenstückelement (16) zusammenwirkt, wobei das verriegelnde Gegenstückelement (15) mit dem Betätigungselement (9) zusammenwirken kann, um die Einschubeinheit (12) als Reaktion auf eine Bewegung des Betätigungselements (9) von der Freigabeposition in die Verriegelungsposition zu bewegen, wobei sich die äußere Einschubposition in einem vorgegebenen Einschubabstand von der Einschubposition in Richtung der gelösten Position befindet, und
das freigebende Gegenstückelement (16) ist zum Zusammenwirken mit dem Betätigungselement (9) zum Bewegen der Einschubeinheit (12) von der eingeschobenen Position in eine äußere Freigabeposition in Bezug auf das Gehäuse (13,) als Reaktion auf eine Bewegung des Betätigungselements (9) von der Verriegelungsposition in die Freigabeposition, ausgelegt, wobei die äußere Freigabeposition in einem vorgegebenen Freigabeabstand von der eingeschobenen Position in die gelöste Position angeordnet ist,
**dadurch gekennzeichnet dass**
das Betätigungselement (9) über eine außermittige Schwenkverbindung (91) mit dem Griff (2) schwenkbar verbunden ist, wobei die außermittige Schwenkverbindung (91) in einem Abstand von einer Schwenkachse des Griffs (2) angeordnet ist und das Betätigungselement (9) in Bezug auf den Griff (2) schwenkbar ist, und
die außermittige Schwenkverbindung (91) umfasst
eine Schwenkwelle (912), die an einem der Griffe (2) und dem Betätigungselement (9) vorgesehen ist, wobei die Schwenkwelle (912) ein freies Ende aufweist; und
eine Verbindungsöffnung (919), die auf der anderen Seite des Griffs (2) und des Betätigungselements (9) vorgesehen ist, wobei die Verbindungsöffnung (919) zur Aufnahme des freien Endes der Schwenkwelle (912) zum Erreichen der außermittigen Schwenkverbindung (91) angepasst ist.

2. Einschubbaugruppe nach Anspruch 1, **dadurch gekennzeichnet dass** die Schwenkwelle (912) am Griff (2) und die Anschlussöffnung (919) am Betätigungselement (9) vorgesehen ist.

3. Einschubbaugruppe nach Anspruch 1, **dadurch gekennzeichnet, dass** das Betätigungselement (9) über eine Führungsschlitzverbindung (92) mit dem Einheitenkörper (121) verbunden ist, wobei die Führungsschlitzverbindung (92) einen Führungsschlitz (921) aufweist, der an einem der Betätigungselemente (9) und dem Einheitenkörper (121) vorgesehen ist, und einen Schlitzstift (922), der auf der anderen Seite des Betätigungselements (9) und des Einheitenkörpers (121) vorgesehen ist, wobei der Schlitzstift (922) zum Zusammenwirken mit dem Führungsschlitz (921) durch Einschieben in den Führungsschlitz (921) angepasst ist.

4. Einschubbaugruppe nach Anspruch 3, **dadurch gekennzeichnet dass** sich der Führungsschlitz (921) linear erstreckt.

5. Einschubbaugruppe nach Anspruch 3 oder 4, **dadurch gekennzeichnet dass** der Führungsschlitz (921) am Betätigungselement (9) und der Schlitzstift (922) am Einheitenkörper (121) vorgesehen ist.

6. Einschubbaugruppe nach Anspruch 3, **dadurch gekennzeichnet, dass** sowohl die Verriegelungsfläche (915) als auch die Freigabefläche (916) ebene Flächen sind, wobei die Verriegelungsfläche (915) einen Winkel α in Bezug auf eine Mittellinie (901) des Betätigungselements bildet, die sich zwischen einem Mittelpunkt der Verbindungsöffnung (919) und einem Mittelpunkt des Führungsschlitzes (921) erstreckt, und die Freigabefläche (916) einen Winkel β in Bezug auf die Mittellinie (901) des Betätigungselements bildet.

7. Einschubbaugruppe nach Anspruch 6, **dadurch gekennzeichnet dass** sowohl der Winkel α als auch der Winkel β in einem Bereich von 30° bis 70° vorliegen.

8. Einschubbaugruppe nach einem der Ansprüche 1, 6 oder 7, **dadurch gekennzeichnet dass** das verriegelnde Gegenstückelement (15) eine Umfangsfläche umfasst, die mit der Verriegelungsfläche (915) zusammenwirken kann, und das freigebende Gegenstückelement (16) eine Umfangsfläche umfasst, die mit der Freigabefläche (916) zusammenwirken kann, wobei jede der Umfangsflächen eine symmetrische und zylindrische Fläche mit einer Symmetrieachse parallel zur Schwenkachse des Griffs (2) ist.

9. Einschubbaugruppe nach Anspruch 1, **dadurch gekennzeichnet dass** mindestens eines der Folgenden: die Schwenkwelle (912), das verriegelnde Gegenstückelement (15) und das freigebende Gegenstückelement (16) durch einen Teil einer Schraube gebildet ist.

10. Einschubbaugruppe nach einem beliebigen der vorhergehenden Ansprüche, **dadurch gekennzeichnet dass** das verriegelnde Gegenstückelement (15) und das freigebende Gegenstückelement (16) voneinander beabstandet und auf einer vertikalen Linie angeordnet sind, wobei die vertikale Linie parallel zu einer vertikalen Richtung (Dᵥₑᵣₜ) senkrecht zur Schwenkachse des Griffs (2) und einer Montagerichtung (Dₘₙₜ) ist, wobei die Montagerichtung (Dₘₙₜ) eine Richtung ist, in der die Einschubeinheit (12) beim Verbinden der Einschubeinheit (12) mit dem Gehäuse (13) einschiebbar ist.

11. Einschubbaugruppe nach einem beliebigen der vorhergehenden Ansprüche, **dadurch gekennzeichnet dass** die außermittige Schwenkverbindung (91) so angeordnet ist, dass das Drehen des Griffs (2) von der Montageposition in die Normalposition die Schwenkwelle (912) nach oben und in eine Ablöserichtung (D_{dtc}) bewegt, wobei die Aufwärtsrichtung eine Richtung parallel zur vertikalen Richtung (Dᵥₑᵣₜ) und weg von der Führungsschlitzverbindung (92) ist, wobei die Ablöserichtung (D_{dtc}) eine Richtung entgegengesetzt zur Montagerichtung (Dₘₙₜ) ist.

12. Einschubbaugruppe nach einem beliebigen der vorhergehenden Ansprüche, **dadurch gekennzeichnet dass** das Betätigungselement (9) in der Verriegelungsposition mit dem verriegelnden Gegenstück (15) zusammenwirken kann, um eine Bewegung der Einschubbaugruppe (12) aus der eingeschobenen Position in die gelöste Position zu verhindern.

## Revendications

1. Ensemble d'unité enfichable comprenant un boîtier (13) et une unité enfichable (12) disposée de sorte à être raccordée de manière détachable au boîtier (13), l'unité enfichable (12) présentant une position enfichée et une position détachée par rapport au boîtier (13) ;
l'unité enfichable (12) comprenant un corps d'unité (121), un manche (2) et un élément d'actionnement (9), le manche (2) étant raccordé de manière pivotante au corps d'unité (121) pour pivoter entre une position normale et une position de montage par rapport au corps d'unité (121), l'élément d'actionnement (9) étant raccordé de manière mobile au corps d'unité (121) pour le mouvement entre une position de verrouillage et une position de libération par rapport au corps d'unité (121), le manche (2) étant raccordé en fonctionnement à l'élément d'actionnement (9) de sorte que le pivotement du manche (2) de la position de montage à la position normale déplace l'élément d'actionnement (9) de la position de libération à la position de verrouillage et le pivotement du manche (2) de la position normale à la position de montage déplace l'élément d'actionnement (9) de la position de verrouillage à la position de libération ;
dans lequel le boîtier (13) comprend un élément de contrepartie de verrouillage (15) et un élément de contrepartie de libération (16), l'élément d'actionnement (9) comprend une surface de verrouillage (915) agencée pour coopérer avec l'élément de contrepartie de verrouillage (15), et une surface de libération (916) agencée pour coopérer avec l'élément de contrepartie de libération (16), l'élément de contrepartie de verrouillage (15) étant adapté pour coopérer avec l'élément d'actionnement (9) pour déplacer l'unité enfichable (12) d'une position d'enfichage extérieure à la position enfichée en réponse au mouvement de l'élément d'actionnement (9) de la position de libération à la position de verrouillage, la position d'enfichage extérieure étant si-tuée à une distance d'enfichage prédéterminée de la position enfichée vers la position détachée, et
l'élément de contrepartie de libération (16) est adapté pour coopérer avec l'élément d'actionnement (9) pour déplacer l'unité enfichable (12) de la position enfichée à une position de libération extérieure par rapport au boîtier (13) en réponse au mouvement de l'élément d'actionnement (9) de la position de verrouillage à la position de libération, la position de libération extérieure étant située à une distance de libération prédéterminée de la position enfichée vers la position détachée,
**caractérisé en ce que**
l'élément d'actionnement (9) est raccordé de manière pivotante au manche (2) au travers d'une connexion pivotante excentrée (91), la connexion pivotante excentrée (91) étant située à une distance d'un axe de pivotement du manche (2) et permettant à l'élément d'actionnement (9) de pivoter par rapport au manche (2), et
la connexion pivotante excentrée (91) comprend
un arbre pivotant (912) prévu sur un du manche (2) et de l'élément d'actionnement (9), l'arbre pivotant (912) présentant une extrémité libre ; et
une ouverture de connexion (919) prévue sur l'autre du manche (2) et de l'élément d'actionnement (9), l'ouverture de connexion (919) étant adaptée pour recevoir l'extrémité libre de l'arbre pivotant (912) pour atteindre la connexion pivotante excentrée (91).

2. Ensemble d'unité d'enfichage selon la revendication 1, **caractérisé en ce que** l'arbre pivotant (912) est prévu sur le manche (2), et l'ouverture de connexion (919) est prévue sur l'élément d'actionnement (9).

3. Ensemble d'unité d'enfichage selon une quelconque revendication précédente, **caractérisé en ce que** l'élément d'actionnement (9) est raccordé au corps d'unité (121) au travers d'une connexion de fente de guidage (92), la connexion de fente de guidage (92) comprenant une fente de guidage (921) prévue sur un de l'élément d'actionnement (9) et du corps d'unité (121), et une goupille de fente (922) prévue sur l'autre de l'élément d'actionnement (9) et du corps d'unité (121), la goupille de fente (922) étant adaptée pour coopérer avec la fente de guidage (921) par coulissement dans la fente de guidage (921).

4. Ensemble d'unité d'enfichage selon la revendication 3, **caractérisé en ce que** la fente de guidage (921) s'étend linéairement.

5. Ensemble d'unité d'enfichage selon la revendication 3 or 4, **caractérisé en ce que** la fente de guidage (921) est prévue sur l'élément d'actionnement (9), et la goupille de fente (922) est prévue sur le corps d'unité (121).

6. Ensemble d'unité d'enfichage selon la revendication 3, **caractérisé en ce qu'**à la fois la surface de verrouillage (915) et la surface de libération (916) sont des surfaces planaires, la surface de verrouillage (915) formant un angle α par rapport à une ligne centrale d'élément d'actionnement (901) qui s'étend entre un point central de l'ouverture de connexion (919) et un point central de la fente de guidage (921), et la surface de libération (916) formant un angle β par rapport à la ligne centrale d'élément d'actionnement (901).

7. Ensemble d'unité d'enfichage selon la revendication 6, **caractérisé en ce qu'**à la fois l'angle α et l'angle β sont dans une plage de 30° à 70°.

8. Ensemble d'unité d'enfichage selon l'une quelconque des revendications 1, 6 ou 7, **caractérisé en ce que** l'élément de contrepartie de verrouillage (15) comprend une surface périphérique adaptée pour coopérer avec la surface de verrouillage (915), et l'élément de contrepartie de libération (16) comprend une surface périphérique adaptée pour coopérer avec la surface de libération (916), chacune des surfaces périphériques étant une surface symétrique et cylindrique présentant un axe de symétrie parallèle à l'axe de pivotement du manche (2).

9. Ensemble d'unité d'enfichage selon la revendication 1, **caractérisé en ce qu'**au moins un de ce qui suit : l'arbre pivotant (912), l'élément de contrepartie de verrouillage (15) et l'élément de contrepartie de libération (16) est formé par une portion d'une vis.

10. Ensemble d'unité d'enfichage selon une quelconque revendication précédente, **caractérisé en ce que** l'élément de contrepartie de verrouillage (15) et l'élément de contrepartie de libération (16) sont espacés et situés sur une ligne verticale, la ligne verticale étant parallèle à une direction verticale (Dᵥₑᵣₜ) perpendiculaire par rapport à la fois à l'axe pivotant du manche (2) et à une direction de montage (Dₘₙₜ), la direction de montage (Dₘₙₜ) étant une direction dans laquelle l'unité enfichable (12) est adaptée pour être poussée lors de la connexion de l'unité enfichable (12) avec le boîtier (13).

11. Ensemble d'unité d'enfichage selon une quelconque revendication précédente, **caractérisé en ce que** la connexion pivotante excentrée (91) est située de sorte que la rotation du manche (2) de la position de montage à la position normale déplace l'arbre pivotant (912) vers le haut et dans une direction de détachement (D_{dtc}), la direction vers le haut étant une direction parallèle à la direction verticale (Dᵥₑᵣₜ) et dirigée loin de la connexion de fente de guidage (92), la direction de détachement (D_{dtc}) étant une direction opposée à la direction de montage (Dₘₙₜ).

12. Ensemble d'unité d'enfichage selon une quelconque revendication précédente, **caractérisé en ce que** l'élément d'actionnement (9) est adapté, alors qu'il est dans la position de verrouillage, pour coopérer avec l'élément de contrepartie de verrouillage (15) afin d'empêcher le mouvement de l'unité enfichable (12) de la position enfichée vers la position détachée.
